# EUROPÄISCHE PATENTSCHRIFT

(11) **EP 1 803 967 B1**
(45) Veröffentlichungstag und Bekanntmachung des Hinweises auf die Patenterteilung: **03.08.2016**
(21) Anmeldenummer: 06008724.4
(22) Anmeldetag: 27.04.2006
(51) Int. Cl.: F16F 15/027, G03F 7/20, G05D 19/02, B23Q 1/38, F16F 15/02

(54) **Schwingungsisolationssystem mit Störgrössenaufschaltung von vorhersehbaren Kraftstörungen**
Vibration isolating system with stabilisation of variables with respect to predictable force disturbances
Système d'isolation de vibrations avec stabilisation de variables relatif aux perturbations de force prévoyables

(30) Priorität: 30.12.2005 EP 05028718
(43) Veröffentlichungstag der Anmeldung: 04.07.2007
(73) Patentinhaber: Integrated Dynamics Engineering GmbH, 65479 Raunheim (DE)
(72) Erfinder: Heiland, Peter, 65379 Raunheim (DE)
(74) Vertreter: Blumbach Zinngrebe

(56) Entgegenhaltungen:
- EP-A1- 1 382 415
- EP-A2- 0 202 880
- WO-A-03/064763
- DE-A1- 19 946 061
- US-A1- 2001 040 324

## Beschreibung

### Gebiet der Erfindung

Die Erfindung bezieht sich auf ein Schwingungsisolationsystem zur Stützung und Schwingungsentkopplung einer Last gegenüber einer Unterlage und auf ein Verfahren zur Störgrößenaufschaltung von vorhersehbaren Kraftstörungen bei einem Schwingungsisolationssystem.

### Hintergrund der Erfindung

In der Halbleiterindustrie werden Schwingungsisolationssysteme eingesetzt, um empfindliche Mess- und Prozessgeräte gegenüber Schwingungen des Bodens oder des Gebäudes zu isolieren. Üblicherweise bestehen derartige Schwingungsisolationssysteme aus einem passiven Isolationssystem, z.B. weichen Federn, oder aus der Kombination von aktiven und passiven Elementen in einem solchen Schwingungsisolationssystem, das die Aufgabe hat, niederfrequente seismische Vibrationen oder andere Störungen aufzufangen.

Zu diesen Störungen zählen auch induzierte Vibrationen eines Objekttisches oder einer Positionierungseinheit. Solche Störungen treten in der Halbleiterindustrie beispielsweise auf, wenn Wafer mittels optischer Systeme untersucht werden sollen. Vor und nach dieser optischen Untersuchung wird der Wafer durch die Positioniereinheit, die sich auf dem schwingungsisolierten Aufbau befindet, relativ zur optischen Untersuchungseinheit bewegt. Beim Beschleunigen und Verzögern der Positioniereinheit entstehen masseninduzierte oder andere Störkräfte und Störschwingungen.

Das Dokument DE 698 17 7150 T2 zeigt ein Gaslager für ein Schwingungsisolationssystem.

Das Dokument EP 1 382 415 A1 zeigt eine aktive Schwingungsdämpfung für eine Werkzeugmaschine.

Das Dokument EP 0 202 880 A2 zeigt ein System zur Reduzierung seismischer Schwingungen für Lithographiegeräte Zusammenfassung der Erfindung

Der Erfindung liegt die Aufgabe zugrunde, den Einfluss von masseninduzierten oder anderen Störungen auf eine gelagerte, positionsgeregelte Masse, z.B. ein Lithographiegerät zur Belichtung von Halbleiterbauteilen, klein zu halten.

Die Aufgabe der Erfindung wird mittels des in Anspruch 1 beschriebenen Verfahrens gelöst.
Das Schwingungsisolationssystem mit Störgrößenaufschaltung umfasst hauptsächlich eine schwingungsisolierte Untersuchungs- oder Bearbeitungseinheit für die Halbleiterindustrie, z.B. ein Lithographiegerät, eine Positioniereinheit mit darauf befindlichem Substrat, wie einem Wafer, eine Apparatur für die Messung von Störschwingungen und eine Regeleinheit für die Aufschaltung von Signalen auf das Schwingungsisolationssystem.

Für die Schwingungsisolation der Untersuchungs- oder Bearbeitungseinheit werden Federsysteme verwendet. Können im konkreten Anwendungsfall Schwingungen im Bereich der

Für die Schwingungsisolation der Untersuchungs- oder Bearbeitungseinheit werden Federsysteme verwendet. Können im konkreten Anwendungsfall Schwingungen im Bereich der Resonanzfrequenz der Einheit auftreten, so werden die Federsysteme durch Dämpfer ergänzt.

Die Positioniereinheit bewegt das Substrat oder Werkstück an den Untersuchungs- oder Bearbeitungsort. Nach Abschluss der Untersuchung oder der Bearbeitung wird das Substrat wieder entfernt. Diese Bewegungen bedingen Beschleunigungen- und Verzögerungen der Positioniereinheit und des Substrats. Sowohl bei der Beschleunigung als auch der Verzögerung der Positioniereinheit treten masseninduzierte Kräfte auf, die sich auf die Untersuchungs- oder Bearbeitungseinheit übertragen. Diese masseninduzierten Kräfte werden von der Messapparatur als Störschwingungen festgestellt. Da die Positioniereinheit sich wiederholende Bewegungen ausführt, sind diese Störschwingurigen nach Art und zeitlichem Auftreten von vorhersehbarer Natur.

Die Regeleinheit leitet Signale an das Schwingungsisolationssystem, um die masseninduzierten Kräfte auszugleichen und auf diese Weise den Schwingungszustand, in dem sich die Untersuchung- oder Bearbeitungseinheit vor Auftreten der Störschwingungen befunden hat, zu erhalten. Die von der Regeleinheit an das Schwingungsisolationssystem geleiteten Signale werden entweder vorab mittels mathematischer Methoden berechnet oder experimentell bestimmt.

Die so vorab bestimmten Signale werden in einem Speicher, der Teil der Regeleinheit ist, abgelegt und in zeitlicher Abstimmung mit den nach Zeitpunkt und Art vorhersehbaren Bewegungen der Positioniereinheit auf das Schwingungsisolationssystem geschaltet.

### Kurze Beschreibung der Zeichnungen

Ausführungsbeispiele der Erfindung werden anhand der Zeichnungen beschrieben.

Dabei zeigt:
- Fig. 1: eine schematische Darstellung eines aktiven Schwingungsisolationssystems mit Störgrößenaufschaltung,
- Fig. 2: eine schematische Darstellung der Verwendung eines -aktiven Schwingungsisolationssystems zur Unterdrückung von Luftdruckschwankungen,
- Fig. 3: eine schematische Darstellung der Verwendung des aktiven Schwingungsisolationssystems bei einem typischen Immersionslithographiesystem,
- Fig. 4: eine schematische Darstellung eines Immersionslithographiesystems während der Belichtung eines Wafers,
- Fig. 5: eine schematische Darstellung eines Immersionslithographiesystems während des Austauschs eines Wafers,
- Fig. 6: eine schematische Darstellung der Verwendung des aktiven Schwingungsisolationssystems im Zusammenhang mit der Verwendung eines Roboters für den Transport des Wafers,
- Fig. 7.: eine schematische Darstellung der Verwendung des aktiven Schwingungssystems im Zusammenhang mit dem Einsatz einer Maske zur Belichtung eines Wafers.

### Detaillierte Beschreibung

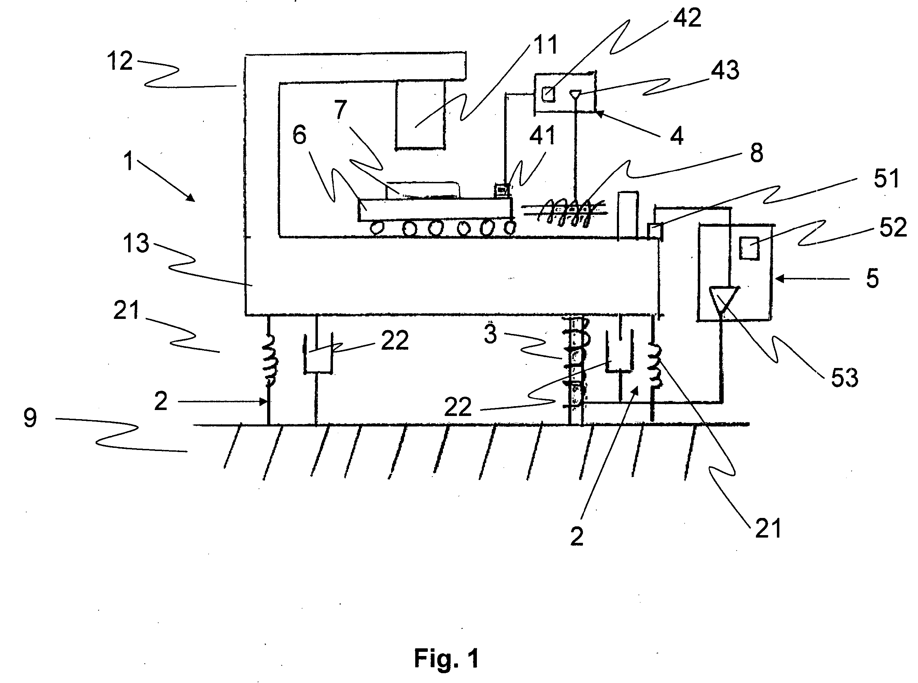

Der generelle Aufbau eines aktiven Schwingungsisolationssystems mit Störgrößenaufschaltung ist in Fig. 1 dargestellt. Das aktive Schwingungsisolationssystem umfasst im wesentlichen eine Last 1, beispielsweise ein'zum Einsatz in der Halbleiterindustrie dienendes Lithographiegerät mit optischem Arm 11, Aufhängevorrichtung 12 für den optischen Arm 11 und Basisplatte 13, Mittel zur weichen Abfederung 2 der Last 1 in allen drei Raumrichtungen gegenüber einer Unterlage 9, beispielsweise dem Aufstellboden, Aktormittel 3 und 8 zur Einleitung von Kräften auf die Last 1, und jeweils eine Regeleinheit 4 und 5, die Sensormittel 41 bzw. 51 und Steuermittel 42, 52 zur Betätigung der Aktormittel 3 und 8 in Abhängigkeit von den Sensormitteln 41 und 51 umfassen. Die Sensormittel 41, 51 können zur Messung von Positionen, von Geschwindigkeiten oder von Beschleunigungen ausgebildet sein.

Die Mittel zur weichen Abfederung 2 umfassen eine oder mehrere Federn 21 niedriger Steifigkeit, deren Aufgabe es ist, die Last 1 insbesondere gegen seismische und Gebäudeschwingungen zu isolieren. Sofern im konkreten Anwendungsfall Schwingungen auftreten können, deren Frequenz im Bereich der Resonanzfrequenz der Last 1 liegt, werden die Federn 21 durch Dämpfer 22 ergänzt. Die Federn 21, ggf. ergänzt um die Dämpfer 22, bilden für sich genommen ein passives Schwingungsisolationssystem.

Auf der Basisplatte 13 befindet sich eine bewegliche Verbindungseinrichtung oder Positioniereinrichtung 6 mit darauf befindlichem Substrat 7, das ein Werkstück, insbesondere ein Wafer sein kann. Die Positioniereinrichtung 6 bewegt das Substrat 7 an einen Untersuchungs- oder Bearbeitungsort. Der optische Arm 11, der ein optisches Linsensystem aufweist, und die Basisplatte 13 bilden eine erste große Masse m₁ und die Positioniereinrichtung 6 mit dem Substrat 7 bilden eine zweite kleine Masse m₂. Hierbei ist die erste große Masse m₁ mindestens um einen Faktor 10 größer sein als die zweite kleine Masse m₂. Sofern die Last 1 ein Lithographiegerät für die Halbleiterindustrie ist, wird das Substrat 7 von der Positioniereinrichtung 6 unterhalb des optischen Arms 11 platziert, um dort untersucht oder bearbeitet, insbesondere belichtet, zu werden. Normalerweise werden unterschiedliche Stellen des Substrats 7 untersucht, was eine Verschiebung der Positioniereinrichtung 6 bedeutet. Nach Beendigung der Untersuchung oder Bearbeitung entfernt die Positioniereinrichtung 6 das Substrat 7 vom Untersuchungs- oder Bearbeitungsort. Alle diese Bewegungen bedingen Beschleunigungen und Verzögerungen der Positioniereinrichtung 6 und des Substrats 7. Bei diesen Beschleunigungen und Verzögerungen der Positioniereinrichtung 6 und des Substrats 7 treten masseninduzierte Kräfte auf, die sich auf die Massen m₁ und m₂ übertragen und dort an sich geringfügige Vibrationen verursachen, die jedoch wegen der Empfindlichkeit des Gerätes unterdrückt werden sollen.

Aufgrund der Belegungen der Positioniereinrichtung 6 und des Substrats 7 treten neben den masseninduzierten Kräften Luftdruckschwankungen auf, die über die Luft ebenfalls Kräfte auf das Gerät übertragen.

Der zeitliche Verlauf der vektoriellen Summe dieser Kräfte, sowohl der masseninduzierten als auch der durch Luftdruckschwankungen verursachten, kann nach Betrag und Richtung erfasst werden, indem für jeden Freiheitsgrad des Systems der zeitliche Verlauf des Betrages der Kraft gemessen wird. Eine graphische Darstellung dieser Werte des Betrages der Kraft würde eine Krafttrajektorie ergeben.

Diese Kräfte werden von den Sensormitteln 41 und 51 als Störschwingungen festgestellt. Hierzu sind die Sensormittel 41 und 51 bevorzugt als Beschleunigungssensoren, Inertialsensoren oder Seismometer ausgebildet. Die Bewegungen der Positioniereinheit 6 wiederholen sich im Rahmen der aufeinander folgenden Untersuchungen oder Bearbeitungen desselben Substrates 7 oder mehrerer einzelner Substrate 7. Diese Bewegungen der Positioniereinheit 6 und des Substrats 7 sind daher nach Art und zeitlichem Auftreten vorhersehbar.

Aufgrund dieser Vorhersehbarkeit werden von der Regeleinheit 4 oder 5 über die Aktormittel 3 oder 8 geeignete "Gegenkräfte" auf die Masse m₁ oder m₂ ausgeübt, so dass im Ergebnis deren ursprünglicher Zustand, d. h. der Verharrungszustand oder der Schwingungszustand vor dem Auftreten der masseninduzierten Kräfte und der durch Luftdruckschwankungen verursachten Kräfte, weitgehend erhalten bleibt. Die Gegenkräfte werden vorab bestimmt. Dies kann mittels zwei Methoden geschehen. Entweder werden die Gegenkräfte mittels mathematischer Methoden bestimmt, oder vorab experimentell bestimmt. Die so bestimmten Werte für jeden Freiheitsgrad des Systems werden als eine Reihe von Werten, die den zeitlichen Verlauf des Betrags der Kraft darstellen, im Speicher 42 der Regeleinheit 4 oder im Speicher 52 der Regeleinheit 5 gespeichert und im Bedarfsfall abgerufen.

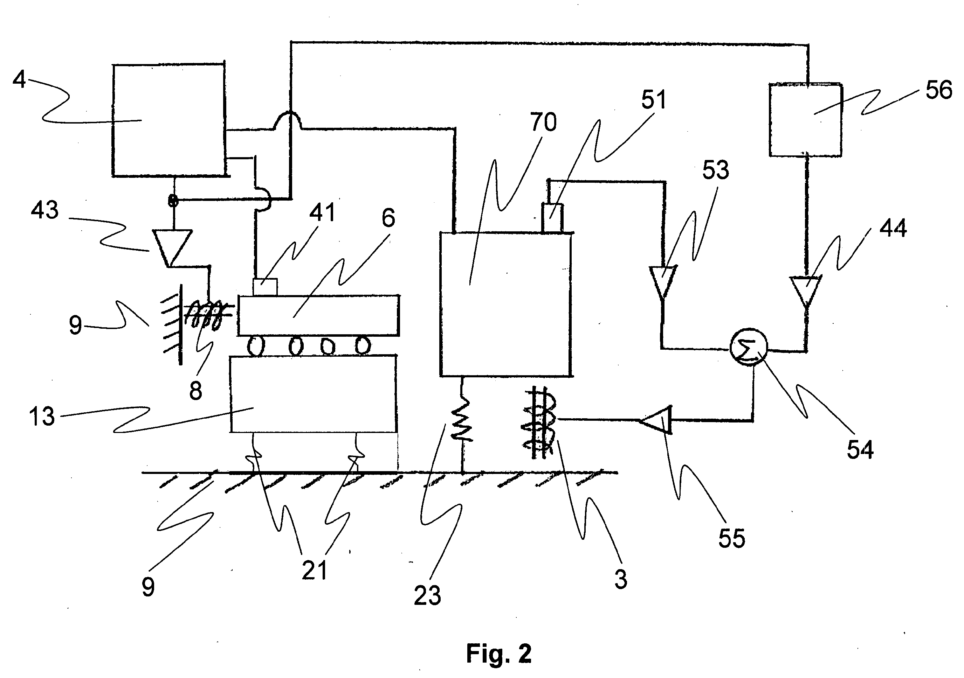

Fig. 2 zeigt in schematischer Darstellung den Aufbau eines aktiven Schwingungsisolationssystems bei der Verwendung zur Unterdrückung von Luftdruckschwankungen. Die Positioniereinrichtung 6 ist auf der Basisplatte 13 beweglich gelagert, die über Federn 21 in allen drei Raumrichtungen gegen die Unterlage 9 schwingungsisoliert ist. Die Bewegungen der Positioniereinrichtung 6 werden über einen Sensor 41 zur Regeleinheit 4, beispielsweise einen Mikrocomputer weitergegeben. Die Regeleinheit 4 erzeugt Steuersignale, die über die Steuereinheit 43 an den Aktor 8 weitergegeben werden. Gleichzeitig erzeugen die Bewegungen der Positioniereinrichtung 6 Luftdruckschwankungen, die sich auf eine Ausgleichsmasse 70 übertragen, die z.B. den optischen Arm 11 eines Lithographiesystems darstellen kann. Die durch diese Luftdruckschwankungen verursachten Bewegungen der Ausgleichsmasse 70 werden von den Sensormitteln 51 über ein Steuermittel 53 an einen Summierer 54 weitergegeben. Die Regeleinheit 4 erhält von den Sensormitteln 41 Sensorsignale und gibt Sensorsignale an das Steuermittel 44. Diese Steuersignale können von einem analogen oder digitalen Filter 56 modifiziert werden, um die Störgrößenaufschaltung zu optimieren, beispielsweise in Hinblick auf Beschleunigungs- und Positionssignale der beteiligten Positioniereinheit 6. Der Summierer 54 erhält neben den Signalen der Sensormittel 51 von der Regeleinheit 4 über die Steuereinheit 44 weitere Steuersignale, die die Bewegungen der Positioniereinheit 6 darstellen. Die Optimierung der Filterstrecke für die Störgrößenaufschaltungssignale kann entweder adaptiv oder alternativ manuell durch Beobachtung vorgenommen werden. Die Summe der beiden beim Summierer 54 eintreffenden Steuersignale werden über eine Steuereinheit 55 an den Aktor 3 weitergeleitet. Dieser Aktor 3 überträgt Gegenkräfte auf die Ausgleichsmasse 70, um den Zustand der Ausgleichsmasse 70, der vor dem Auftreten der Luftdruckschwankungen geherrscht hatte, wiederherzustellen bzw., sofern die Signale zeitgerecht zur Verfügung gestellt wurden, zu erhalten.

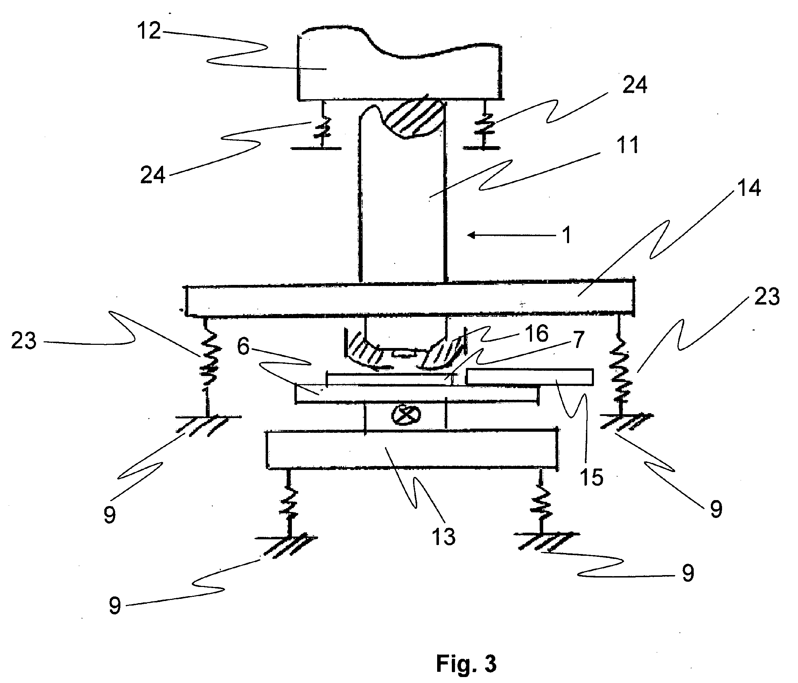

Fig. 3 zeigt in einer weiteren Ausführungsform der Erfindung die Verwendung des aktiven Schwingungsisolationssystems mit Störgrößenaufschaltung bei einem typischen Immersionslithographiesystem.

Hierbei stellt das Immersionslithographiesystem die Last 1 dar und umfasst im wesentlichen den optischen Arm 11 mit seiner Aufhängevorrichtung 12. Eine mit dem optischen Arm 11 verbundene Metrologieplatte 14, die zusammen mit dem optischen Arm 11 in vertikaler Richtung bewegt werden kann, bildet den Referenzkörper für das gesamte Lithographiesystem. Unterhalb des optischen Arms 11 befindet sich eine Basisplatte 13, die keine Verbindung mit dem optischen Arm 11 haben muss. Die Last 1 und die Basisplatte 13 sind jeweils mittels Federn 21, 23, 24, die jeweils ein passives Schwingungsisolationssystem darstellen können, gegenüber der Unterlage 9 in allen drei Raumrichtungen schwingungsisoliert. Die zweite kleine Masse m₂ wird in dieser Ausführungsform der Erfindung von der Positioniereinrichtung 6, die wiederum das Substrat 7 trägt, gebildet.

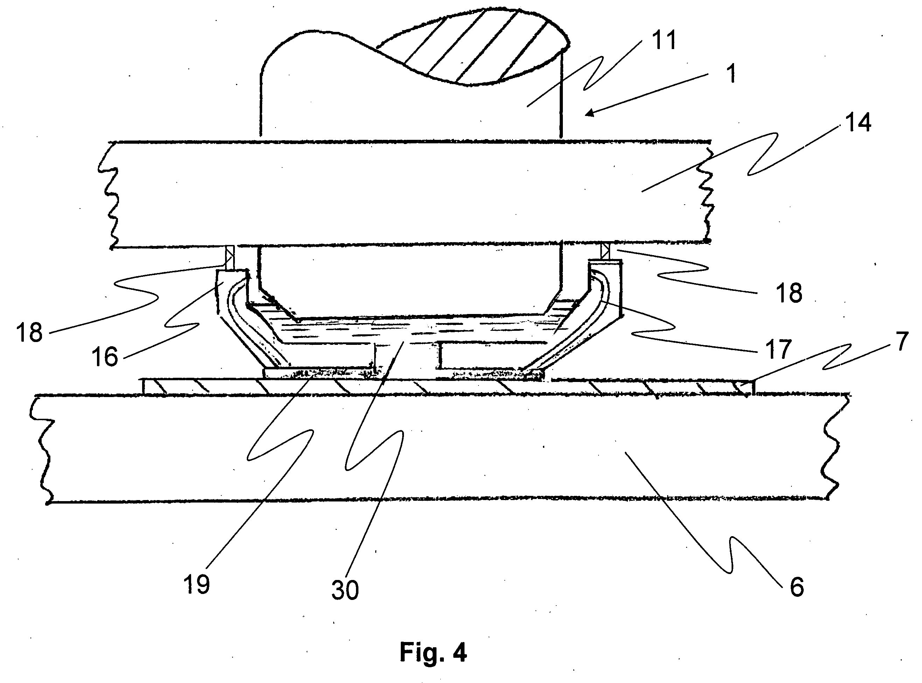

### Fig. 4 zeigt eine Detailansicht des

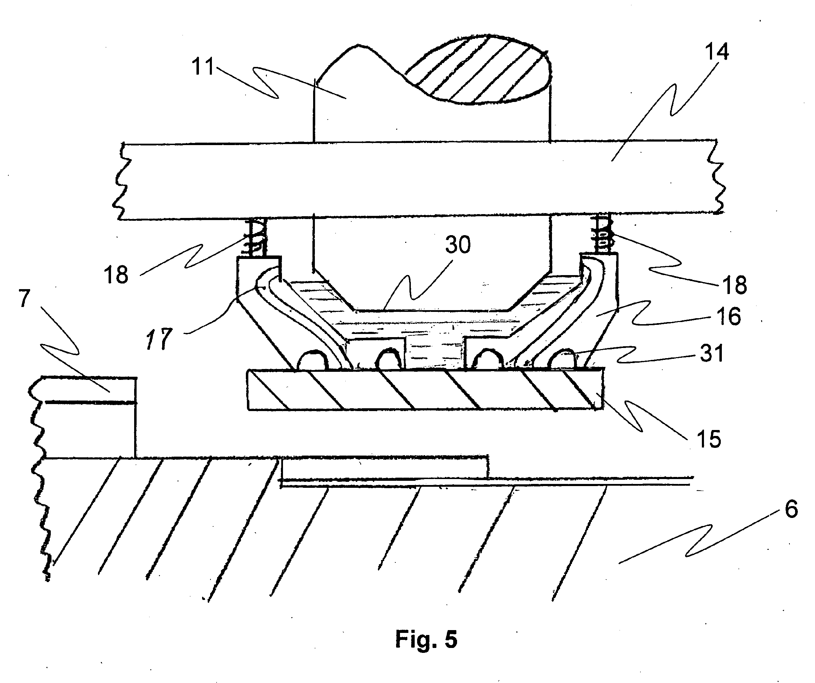

Immersionslithographiegerätes der Fig. 3 mit Substrat 7, während dieses bearbeitet wird. Eine Schale 16 ist mit einer mittigen Öffnung und mit Saugkanälen 17 versehen, die am unteren Rand der Schale 16 eine Saugwirkung entfalten. Die Schale 16 ist mit der Metrologieplatte 14 über Aktoren 18 verbunden. In der Schale 16 ist ein Wasserbad 30 angeordnet. Am unteren Ende des optischen Arms 11 ist das optische Linsensystem über einen Immersions-Wasserfilm 19 mit dem Substrat 7 verbunden. Dieser Wasserfilm 19 entsteht in dem Spalt zwischen der Schale 16 und dem Substrat 7. Nach der Belichtung des Substrats 7 wird dieses entfernt, was zu einem Abfließen des Wassers 30 aus der Schale 16 führen würde. Um dieses Abfließen zu verhindern, wird eine Kappe 15 (Fig. 3), die sich während der Belichtung unmittelbar neben dem Substrat 7 auf der Positioniereinrichtung 6 befindet und dort mit Vakuum gehalten wird, durch Verfahren der Positioniereinrichtung 6 unterhalb der mittigen Öffnung der Schale 16 verbracht und mit Druckluft anstelle des Substrats 7 an die Schale 16 gedrückt und dort mit Vakuum festgehalten, so dass das Herausfließen des Wassers 30 aus der Schale 16 verhindert wird. Dieser Zustand wird in Fig. 5 gezeigt. Zusätzlich zeigt Fig. 5 weitere Vakuumkanäle 31, über die die Kappe 15 an der Schale 16 fest gehalten wird, nachdem das Substrat 7 entfernt wurde.

Sobald die Kappe 15 die Schale 16 berührt, entstehen masseninduzierte Kräfte, die sich über das Wasserbad 30 auf das gesamte Lithographiesystem 1 übertragen, und es werden Störschwingungen ausgelöst. Diese wiederum sind nach Art und zeitlichem Auftreten vorhersehbar, so dass geeignete Gegenkräfte gemäß dem bereits beschriebenen Verfahren über die Regeleinheit 4 mit dem Speicher 42 auf die Aktoren 18 und damit die Last 1 übertragen werden können. Die Aktoren 18 sind als Linearaktoren ausgebildet.

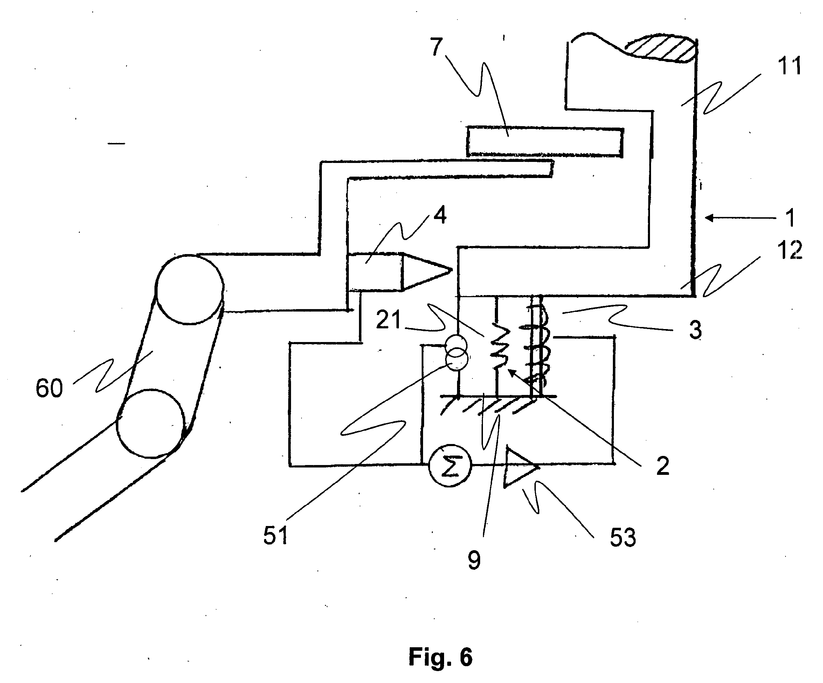

Fig. 6 zeigt in einer noch weiteren Ausführungsform der Erfindung die Verwendung des aktiven Schwingungsisolationssystems mit Störgrößenaufschaltung im Zusammenhang mit der Verwendung eines Roboters 60 für den Transport des Substrats 7.

In dieser Ausführungsform der Erfindung wird die erste große Masse m₁ oder Last 1 wiederum von einem Untersuchungs- oder Bearbeitungsgerät gebildet, das von einem aktiven Schwingungsisolationssystem 2 in allen drei Raumrichtungen gegen die Unterlage 9 schwingungsisoliert wird. Die zweite kleine Masse m₂ wird von einem Roboterarm 60 gebildet, der das Substrat 7 an den Bearbeitungs- oder Untersuchungsort bewegt und dabei an die erste große Masse m₁ oder Last 1 leicht anstößt. Bei dieser Anordnung ist das Substrat 7 als dritte kleine Masse m₃ zu betrachten. Bei jedem Wechsel des Substrats 7 werden durch den Roboterarm 60 masseninduzierte Kräfte auf das Untersuchungs- oder. Bearbeitungsgerät übertragen, die von den Sensormittel 51 als Störschwingungen festgestellt werden. Zum Ausgleich dieser Störschwingungen werden von der Regeleinheit 5 auf die Aktormittel 3 geeignete Gegenkräfte aufgeschaltet, so dass der vor dem Auftreten der masseninduzierten Kräfte herrschende Zustand der Last 1 erhalten bleibt.

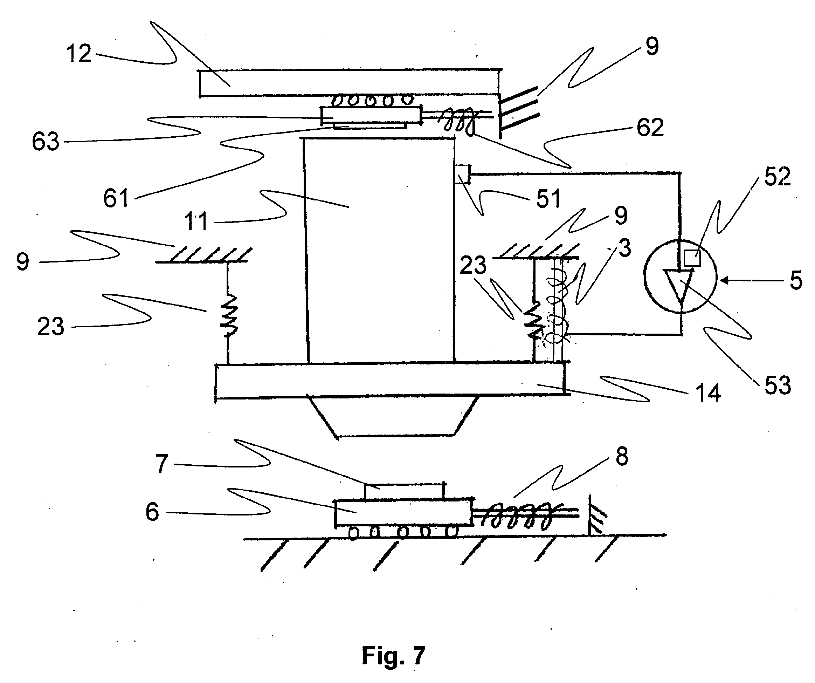

Fig. 7 zeigt in einer noch weiteren Ausführungsform der Erfindung die Verwendung des aktiven Schwingungsisolationssystems im Zusammenhang mit einer weiteren kleinen Masse m₃. Zwischen dem optischem Arm 11 und seiner Aufhängevorrichtung 12 befindet sich eine mittels einer Positioniereinheit 63 beweglich angeordnete Belichtungsmaske 61 für das Substrat 7. Der Positioniereinheit 12 wird die Masse m₃ und der Masse 61 die Masse m₃' zugeordnet. Die Metrologieplatte 14 ist mittels sehr weicher Luftfedern 23 in allen drei Raumrichtungen gegen die Unterlage 9 schwingungsisoliert und bildet zusammen mit dem optischen Arm 11 die große Masse m₁. Die kleine Masse m₂ wird durch die Positioniereinheit 6 zusammen mit dem Substrat 7 gebildet, das eine weitere kleine Masse m₂' darstellt. Sowohl die Bewegungen der Belichtungsmaske 61 als auch die Bewegungen der Positioniereinheit 6 mit dem Substrat 7 können sowohl masseninduzierte als auch durch Luftdruckschwankungen verursachte Kräfte auf den optischen Arm 11 mit der Metrologieplatte 14 übertragen. Die Bewegungen des optischen Arms 11 und der Metrologieplatte 14 werden mittels des Sensors 51 festgestellt und an die Regeleinheit 5 (z.B. einen PID-Regler) weitergeleitet, die den Speicher 52 und die Steuereinheit 53 umfasst, wie mit Fig. 1 erläutert. Über die Steuereinheit 53 werden zum Aktor 3 Steuersignale gesendet, die den Aktor 3 veranlassen, auf die Metrologieplatte 14 Gegenkräfte auszuüben, um den Zustand der Metrologieplatte 14 und damit der Optik 11. wiederherzustellen oder zu erhalten. Alternativ zur Abgabe von Kräften in vorbestimmter Weise können auch die weichen Luftfedern 23 versteift werden (siehe DE 42 33 212 A1). Es werden Versteifungsfaktoren bis zu 100 oder gar 400 bevorzugt. Auf diese Weise wird die Bandbreite der mechanischen Impedanz der Anordnung von 0,5 Hz auf 10 Hz angehoben, d. h. die Auswirkung masseninduzierter oder Luftdruckkräfte auf die Schwingungsanregung der jeweiligen Masse m₁, m₂ oder m₃ reduziert.

Sowohl auf die Belichtungsmaske 61 als auch die Positioniereinheit 6 mit dem Substrat 7 können über Aktoren 62 bzw. 8 ebenfalls Gegenkräfte ausgeübt werden. Hierzu werden von jeweils separaten Regeleinheiten, die aus Gründen der Übersichtlichkeit nicht in Fig.7 eingezeichnet wurden, geeignete Steuersignale an die Aktoren 62 bzw. 8 geleitet.

In weiteren Ausführungsformen der Erfindung können die Sensormittel 41 oder 51 an verschiedenen Stellen angebracht werden, zwischen der Positioniereinrichtung 6 und der ersten großen Masse m₁, als Teil der Positioniereinrichtung 6, als Teil der zweiten kleinen Masse m₂ oder in einer Verbindungseinrichtung der ersten großen Masse m₁ mit der zweiten kleinen Masse m₂. Jedes der Sensormittel umfasst vorzugsweise sechs Inertialsensoren.

## Patentansprüche

1. Verfahren zur Störgrößenaufschaltung von vorhersehbaren Kraftstörungen bei einem Schwingungsisolationssystem zur Stützung und Schwingungsentkopplung einer Last (1) gegenüber einer Unterlage (9), umfassend:
Weiches Abfedern (2) und Abstützen (3, 8) der Last (1) gegenüber der Unterlage (9);
Feststellen (41, 51) des zeitlichen Zustandes der Last (1) bezüglich mindestens eines Freiheitsgrads bzw. einer Raumrichtung, wenn jeweils eine vorgegebene Kraftstörung auf die Last (1) eingewirkt hat;
Speichern (42, 52) des zeitlichen Zustandes der Last (1) als auf die Last einwirkende Krafttrajektorien für jede vorgegebene Kraftstörung, wobei die Krafttrajektorien den zeitlichen Verlauf der Kraftstörung nach Betrag und Richtung darstellen;
Bilden und Speichern von Kompensations-Steuersignalen, die den Krafttrajektorien entgegenstehen,
Abgeben der Kompensations-Steuersignale an Aktormittel (3,8) bei zu erwartender oder anzutreffender Störung in zeitlicher Abstimmung mit dem tatsächlichen Auftreten der Störung..

2. Verfahren nach Anspruch 1,
**dadurch gekennzeichnet, dass** die vorhersehbaren Kraftstörungen auf eine erste, große Masse (m₁) von einer zweiten, kleinen Masse (m₂) ausgeübt wird, wobei die zweite Masse (m₂) zur ersten Masse (m₁) hinzugefügt oder entfernt oder verschoben wird.

3. Verfahren nach Anspruch 2,
**dadurch gekennzeichnet, dass** die vorhersehbaren Kraftstörungen von einer dritten, kleinen Masse (m₃) auf die erste Masse (m₁) oder die zweite Masse (m₂) ausgeübt wird, wobei die dritte Masse (m₃) zur ersten oder zweiten Masse hinzugefügt oder entfernt oder verschoben wird.

4. Verfahren nach Anspruch 1 oder 2,
**dadurch gekennzeichnet, dass** die vorhersehbaren Kraftstörungen wenigstens teilweise auf Luftdruckschwankungen beruhen, die beim Hinzufügen, Entfernen oder Verschieben von Massen (m₁, m₂, m₃) entstehen.

5. Verfahren nach einem der Ansprüche 1 bis 4,
**dadurch gekennzeichnet, dass** die Kompensationsabstützkraft wenigstens teilweise zur Veränderung der Federcharakteristik der Abfederung (2) der Last (1) benutzt wird.

6. Verfahren nach einem der vorstehenden Ansprüche,
**dadurch gekennzeichnet, dass** Krafttrajektorien mehrfach experimentell festgestellt und gespeichert werden.

7. Verfahren nach einem der vorstehenden Ansprüche,
**dadurch gekennzeichnet, dass**
zwischen einer Positioniereinrichtung (6) und einer ersten großen Masse (m₁) eine Anordnung von Sensoren (41) zur Messung von Position, Geschwindigkeit oder von Beschleunigung vorgesehen ist.

8. Verfahren nach Anspruch 8, **dadurch gekennzeichnet,**
**dass** die Sensoren (41) einen Teil der zweiten Positioniereinrichtung (6) bilden.

9. Verfahren nach Anspruch 8, **dadurch gekennzeichnet,**
**dass** die Sensoren (41) einen Teil der zweiten, kleinen Masse (m₂) bilden.

10. Verfahren nach Anspruch 8,
**dadurch gekennzeichnet, dass** die Sensoren (41) in einer Verbindungseinrichtung der ersten großen Masse (m₁) mit der zweiten kleinen Masse (m₂) angeordnet sind.

11. Verfahren nach Anspruch 2,
**dadurch gekennzeichnet, dass** die erste große Masse (m₁) ein Lithographiegerät zur Belichtung von Halbleiterbauteilen ist.

12. Verfahren nach Anspruch 2,
**dadurch gekennzeichnet, dass** die erste große Masse (m1) ein Metrologiesystem für die Bestimmung der Relativposition von zu bearbeitenden Halbleiterbauteilen ist.

13. Verfahren nach Anspruch 2,

14. **dadurch gekennzeichnet, dass** die erste große Masse (m₁) ein Inspektionssystem für die Untersuchung von Halbleiterbauteilen ist.

15. Verfahren nach Anspruch 2,
**dadurch gekennzeichnet, dass** die zweite kleine Masse (m₂) eine Abdeckkappe (15) einer Schale (16) mit einem Wasserbad (30) für eine Immersionsoptik ist.

16. Verfahren nach Anspruch 2,
**dadurch gekennzeichnet, dass** die zweite kleine Masse (m₂) optische Eigenschaften aufweist, aufgrund derer sie einen Teil einer Optik eines Lithographiegerätes bildet.

17. Verfahren nach Anspruch 2,
**dadurch gekennzeichnet, dass** die zweite kleine Masse (m₂) eine Siliziumscheibe umfasst.

18. Verfahren nach Anspruch 3,
**dadurch gekennzeichnet, dass** die dritte kleine Masse (m₃) eine Halbleitermaske (61) zur Belichtung von Halbleiterbauteilen umfasst.

19. Verfahren nach Anspruch 2,
**dadurch gekennzeichnet, dass** die Positioniereinrichtung (6), welche die zweite kleine Masse (m₂) bildet, ein 6-achsiger Positioniertisch ist.

20. Verfahren nach Anspruch 2,
**dadurch gekennzeichnet, dass** die Positioniereinrichtung (6), welche die zweite kleine Masse (m₂) bildet, ein Roboterarm ist.

21. Verfahren nach Anspruch 3,
**dadurch gekennzeichnet, dass** eine weitere Positioniereinrichtung (63) als eine dritte kleine Masse (m₃) vorgesehen ist.

22. Verfahren nach Anspruch 19,
**dadurch gekennzeichnet, dass** die weitere Positioniereinrichtung eine mindestens 3-achsige Positionsregelung mit Abstandssensoren (41) und Linearaktoren (18) zum Halten einer Wasserbadschale (16) bei Immersionslithographiegeräten darstellt.

## Claims

1. A method for feedforward control of predictable force disturbances in a vibration isolation system for supporting a load (1) and decoupling it from vibrations relative to a ground (9), comprising:
softly cushioning (2) and supporting (3, 8) the load (1) with respect to the ground (9);
each time a predetermined force disturbance has acted on the load (1), determining (41, 51) the temporal state of the load (1) with respect to at least one degree of freedom or a spatial direction;
for each predetermined force disturbance, storing (42, 52) the temporal state of the load (1) in the form of force trajectories acting on the load, said force trajectories representing the behaviour of the force disturbance over time in magnitude and direction;
generating and storing compensation control signals opposing said force trajectories;
when a disturbance is anticipated or occurs, supplying the compensation control signals to actuator means (3, 8) in time synchronization with the actual occurrence of the disturbance.

2. The method according to claim 1,
**characterized in that** the predictable force disturbances are exerted on a first, large mass (m₁) by a second, small mass (m₂), when the second mass (m₂) is added to or removed from or moved relative to the first mass (m₁).

3. The method according to claim 2,
**characterized in that** the predictable power disturbances are exerted by a third, small mass (m₃) on the first mass (m₁) or on the second mass (m₂), when the third mass (m₃) is added to or removed from or moved relative to the first or second mass.

4. The method according to claim 1 or 2,
**characterized in that** the predictable force disturbances are at least partially caused by changes in air pressure that arise when masses (m₁, m₂, m₃) are added, removed or displaced.

5. The method according to any of claims 1 to 4,
**characterized in that** the compensation support force is at least partially used for modifying the spring characteristic of the cushioning (2) of the load (1).

6. The method according to any of the preceding claims,
**characterized in that** force trajectories are repeatedly determined by experiments and stored.

7. The method according to any of the preceding claims,
**characterized in that** sensors (41) for measuring position, speed, or acceleration are arranged between a positioning device (6) and a first, large mass (m₁).

8. The method according to claim 7,
**characterized in that** the sensors (41) form part of the second positioning device (6).

9. The method according to claim 7,
**characterized in that** the sensors (41) form part of the second, small mass (m₂) .

10. The method according to claim 7,
**characterized in that** the sensors (41) are arranged in a connection device connecting the first, large mass (m₁) and the second, small mass (m₂).

11. The method according to claim 2,
**characterized in that** the first, large mass (m₁) is a lithography apparatus for exposing semiconductor devices.

12. The method according to claim 2,
**characterized in that** the first, large mass (m₁) is a metrology system for determining the relative position of semiconductor devices to be processed.

13. The method according to claim 2,

14. **characterized in that** the first, large mass (m₁) is an inspection system for inspecting semiconductor devices.

15. The method according to claim 2,
**characterized in that** the second, small mass (m₂) is a cover cap (15) of a basin (16) containing a water bath (30) for an immersion optical system.

16. The method according to claim 2,
**characterized in that** the second, small mass (m₂) has optical properties due to which it forms part of an optical system of a lithography apparatus.

17. The method according to claim 2,
**characterized in that** the second, small mass (m₂) comprises a silicon wafer.

18. The method according to claim 3,
**characterized in that** the third, small mass (m₃) comprises a semiconductor mask (61) for the exposure of semiconductor devices.

19. The method according to claim 2,
**characterized in that** the positioning means (6) which defines the second, small mass (m₂) is a 6-axis positioning table.

20. The method according to claim 2,
**characterized in that** the positioning device (6) which defines the second, small mass (m₂) is a robot arm.

21. The method according to claim 3,
**characterized in that** a further positioning device (63) is provided as a third, small mass (m₃).

22. The method according to claim 19,
**characterized in that** the further positioning device is an at least 3-axis position control including distance sensors (41) and linear actuators (18) for supporting a water bath basin (16) in immersion lithography apparatuses.

## Revendications

1. Procédé de compensation de perturbations de forces prévisibles dans un système d'isolation de vibrations pour le soutien et le découplage de vibrations d'une charge (1) par rapport à un support (9), comprenant :
l'amortissement souple (2) et le soutien (3, 8) de la charge (1) par rapport au support (9),
la détermination (41, 51) de l'état temporaire de la charge (1) par rapport à au moins un degré de liberté ou une direction dans l'espace, lorsque respectivement une perturbation de force prédéfinie a agi sur la charge (1) ;
la mise en mémoire (42, 52) de l'état temporaire de la charge (1) en tant que trajectoires de force agissant sur la charge pour chaque perturbation de force prédéfinie, les trajectoires de force représentant la variation dans le temps de la perturbation de force en fonction de sa valeur et de sa direction ;
la formation et la mise en mémoire de signaux de commande de compensation, qui font obstacle aux trajectoires de force,
la transmission des signaux de commande de compensation vers des moyens d'actionnement (3, 8) dans le cas d'une perturbation attendue ou rencontrée en même temps que l'apparition effective de la perturbation.

2. Procédé selon la revendication 1,
**caractérisé en ce que** les perturbations de forces prévisibles sont exercées sur une première masse de grande taille (m₁) par une deuxième masse de petite taille (m₂),
la deuxième masse (m₂) étant ajoutée ou retirée ou décalée par rapport à la première masse (m₁).

3. Procédé selon la revendication 2,
**caractérisé en ce que** les perturbations de forces prévisibles sont exercées par une troisième masse de petite taille (m₃) sur la première masse (m₁) ou la deuxième masse (m₂), la troisième masse (m₃) étant ajoutée ou retirée ou décalée par rapport à la première ou à la deuxième masse.

4. Procédé selon la revendication 1 ou 2,
**caractérisé en ce que** les perturbations de forces prévisibles reposent au moins en partie sur des variations de la pression de l'air qui se produisent lors de l'ajout, du retrait ou du décalage des masses (m₁, m₂, m₃) .

5. Procédé selon l'une quelconque des revendications 1 à 4,
**caractérisé en ce que** la force de soutien de compensation est utilisée au moins en partie pour modifier la caractéristique d'élasticité de l'amortissement (2) de la charge (1).

6. Procédé selon l'une quelconque des revendications précédentes,
**caractérisé en ce que** les trajectoires de force sont déterminées et mises en mémoire à plusieurs reprises de manière expérimentale.

7. Procédé selon l'une quelconque des revendications précédentes, **caractérisé en ce que** :
un ensemble de capteurs (41) destinés à mesurer la position, la vitesse ou l'accélération est prévu entre un dispositif de positionnement (6) et une première masse de grande taille (m₁).

8. Procédé selon la revendication 8, **caractérisé en ce que** les capteurs (41) font partie du deuxième dispositif de positionnement (6).

9. Procédé selon la revendication 8, **caractérisé en ce que** les capteurs (41) font partie de la deuxième masse de petite taille (m₂) .

10. Procédé selon la revendication 8,
**caractérisé en ce que** les capteurs (41) sont agencés dans un dispositif de liaison entre la première masse de grande taille (m₁) et la deuxième masse de petite taille (m₂).

11. Procédé selon la revendication 2,
**caractérisé en ce que** la première masse de grande taille (m₁) est un appareil de lithographie permettant l'exposition de composants à semi-conducteur.

12. Procédé selon la revendication 2,
**caractérisé en ce que** la première masse de grande taille (m₁) est un système de métrologie pour la détermination de la position relative des composants à semi-conducteur à usiner.

13. Procédé selon la revendication 2,

14. **caractérisé en ce que** la première masse de grande taille (m₁) est un système d'inspection pour l'examen des composants à semi-conducteur.

15. Procédé selon la revendication 2,
**caractérisé en ce que** la deuxième masse de petite taille (m₂) est un couvercle (15) d'un bol (16) comprenant un bain d'eau (30) pour une optique d'immersion.

16. Procédé selon la revendication 2,
**caractérisé en ce que** la deuxième masse de petite taille (m₂) présente des propriétés optiques en raison desquelles elle fait partie d'une optique d'un appareil de lithographie.

17. Procédé selon la revendication 2,
**caractérisé en ce que** la deuxième masse de petite taille (m₂) est une tranche de silicium.

18. Procédé selon la revendication 3,
**caractérisé en ce que** la troisième masse de petite taille (m₃) est un masque à semi-conducteur (61) permettant l'exposition de composants à semi-conducteur.

19. Procédé selon la revendication 2,
**caractérisé en ce que** le dispositif de positionnement (6), lequel forme la deuxième masse de petite taille (m₂), est une table de positionnement à 6 axes.

20. Procédé selon la revendication 2,
**caractérisé en ce que** le dispositif de positionnement (6), lequel forme la deuxième masse de petite taille (m₂), est un bras de robot.

21. Procédé selon la revendication 3,
**caractérisé en ce qu'**un autre dispositif de positionnement (63) est réalisé sous la forme d'une troisième masse de petite taille (m₃).

22. Procédé selon la revendication 19,
**caractérisé en ce que** l'autre dispositif de positionnement est une commande de position à au moins trois axes comprenant des capteurs de distance (41) et des actionneurs linéaires (18) permettant de porter un bol de bain d'eau (16) pour des appareils de lithographie à immersion.
